# EUROPEAN PATENT APPLICATION

(11) **EP 4 450 896 A1**
(43) Date of publication of application: **23.10.2024**
(21) Application number: 23794836.9
(22) Date of filing: 16.03.2023
(51) Int. Cl.: F25B 21/00, C01F 17/36

(54) **USE OF RARE EARTH FLUORIDE SINGLE CRYSTAL IN MAGNETIC REFRIGERATION**

(30) Priority: 24.04.2022 CN 202210435306
(71) Applicant: Institute of Metal Research, Chinese Academy of Sciences, Shenyang, Liaoning 110016 (CN); National Institute for Materials Science, Tsukuba-shi, Ibaraki 305-0047 (JP)
(72) Inventor: LI, Bing, Shenyang, Liaoning 110015 (CN); YUAN, Dongsheng, Tsukuba Ibaraki (JP); LIU, Peng, Shenyang, Liaoning 110015 (CN); GARCIA VILLORA, Encarnacion Antonia, Tsukuba Ibaraki (JP); ZHANG, Zhidong, Shenyang, Liaoning 110015 (CN); SHIMAMURA, Kiyoshi, Tsukuba Ibaraki (JP)
(74) Representative: Tahtadjiev, Konstantin
(86) International application number: PCT/CN2023/081822
(87) International publication number: WO 2023/207400

(57) **Abstract**

The present invention relates to the field of magnetic functional materials. The present invention discloses a use of a rare earth fluoride single crystal in magnetic refrigeration, a magnetic refrigeration method and a magnetic refrigeration device. A magnetocaloric material of the series is lithium rare earth fluoride, with the chemical formula of LiREF₄, wherein RE is one or more of rare earth elements gadolinium, terbium, dysprosium, holmium, erbium, thulium and ytterbium. A magnetocaloric material single crystal of the series has extremely strong magnetic anisotropy. By applying a varying magnetic field of 0-20kOe along the easy magnetization axis direction of the magnetocaloric material, LiGdF₄, LiTbF₄, LiHoF₄, LiDyF₄, LiErF₄, LiYbF₄ and LiTmF₄ obtained isothermal magnetic entropy changes of 50.35J·kg⁻¹·K⁻¹, 21.12J·kg⁻¹·K⁻¹, 24.98J·kg⁻¹·K⁻¹, 24.45J·kg⁻¹·K⁻¹, 21.95J·kg-¹·K⁻¹, 14.7J·kg⁻¹·K⁻¹ and 0.692J·kg⁻¹·K⁻¹, respectively, at 1.8K, 4K, 4K, 1.8K, 1.8K, 1.8K, and 18K. Wherein, the thermal conductivity of LiTbF₄ and LiErF₄ reaches 50W·K⁻¹·m⁻¹ at 25K.

## Description

### BACKGROUND OF THE PRESENT INVENTION

### FIELD OF INVENTION

The present invention belongs to the field of magnetic functional materials, and particularly relates to a giant magnetocaloric effect material that can be driven by a small magnetic field in a low-temperature range.

### DESCRIPTION OF RELATED ARTS

Nowadays, refrigeration technology is well known and widely used in daily life, such as air-conditioners, refrigerators, agriculture and medical, etc. In refrigeration technology, the temperature range below the temperature of liquid hydrogen is called a low-temperature range, which can be applied to cosmic telecommunications, gas liquefaction in quantum computers or chemical industry and ultra-sensitive detectors in space, etc. The refrigeration technology is inseparable with helium, for example, in adiabatic demagnetization refrigeration devices, the superconducting magnet providing the magnetic field needs to be cooled with liquid helium. Both 3He/4He dilution refrigerators and He adsorption refrigerators are heavily rely on helium gas. Compared with the traditional refrigeration methods, the new magnetic refrigeration technology that based on the magnetocaloric effect has the advantages of environmental friendliness, high refrigeration efficiency, low energy consumption, low noise, pollution-free, high stability and high reliability. Therefore, receiving high attention from researchers.

At present, the magnetic working mediums that are relatively mature in low-temperature magnetic refrigeration are garnet series, such as Gd₃Ga₅O₁₂ (GGG) and Dy₃Al₅O₁₂ (DAG). However, in order to gain a greater magnetic entropy change, a large varying magnetic field (0-50kOe) usually needs to be applied to the magnetic working medium, and such magnetic fields require large electromagnets and superconducting magnets. The high cost of the device, complex device design and large volume have severely hindered the widespread application of the magnetic refrigeration technology. Therefore, finding a magnetic working medium that can achieve a large magnetic entropy change driven by a small magnetic field in the low-temperature range is essential for low-temperature magnetic refrigeration.

Thus, in response to the above issues, the present invention provides a magnetocaloric material that can be driven by a small magnetic field and achieve a large magnetic entropy change, and the magnetocaloric material is a lithium rare earth fluoride single crystal.

### SUMMARY OF THE PRESENT INVENTION

The present invention discloses a use of rare earth fluoride single crystal in magnetic refrigeration, the rare earth fluoride single crystal is a lithium rare earth fluoride single crystal. In a low-temperature range, applying a varying magnetic field of 0-20kOe along the easy magnetization direction of this material can obtain a large magnetic entropy change, and this series of materials has good thermal conductivity. The discovery of this material provides the potential for the simplification and widespread application of low-temperature magnetic refrigeration devices.

The technical solution of the present invention is:
A use of a lithium rare earth fluoride single crystal in magnetic refrigeration.

Under the influence of an external magnetic field, the magnetic moments of the lithium rare earth fluoride single crystal sample transition from disordered to ordered. The interaction energy between the atomic magnetic moments and the external magnetic field reduces, decreasing the magnetic entropy and releasing heat to the surroundings. Conversely, during the process of removing the magnetic field, the magnetic moments of the lithium rare earth fluoride single crystal sample transition from ordered to disordered, increasing the magnetic entropy and absorbing energy from the surroundings. When the sample is adiabatic, this condition appears as a temperature change in the lithium rare earth fluoride single crystal sample itself.

The preferred technical solution of the present invention is:
The chemical formula of the lithium rare earth fluoride is LiREF₄, where RE is a rare earth element.

The rare earth element RE is one or more of gadolinium (Gd), terbium (Tb), dysprosium (Dy), holmium (Ho), erbium (Er), thulium (Tm) and ytterbium (Yb).

The lithium rare earth fluoride has a tetragonal scheelite structure.

The lithium rare earth fluoride is a single crystal with extremely strong magnetic anisotropy.

Wherein, the easy magnetization directions of LiGdF₄, LiTbF₄ and LiHoF₄ are parallel to the C-axis, while the easy magnetization directions of LiDyF₄, LiErF₄, LiYbF₄ and LiTmF₄ are perpendicular to the C-axis.

LiGdF₄ demonstrates paramagnetism, LiTmF₄ demonstrates Van Vleck paramagnetism, LiTbF₄ and LiHoF₄ demonstrate ferromagnetism ordering at temperatures below Curie temperature of 2.87K and 1.53K respectively, LiDyF₄, LiErF₄ and LiYbF₄ demonstrate antiferromagnetism ordering at temperatures below Nel temperature of 0.62K, 0.38K and 0.128K respectively.

The application temperature range of the lithium rare earth fluoride single crystal is a low-temperature range below 20K.

The isothermal magnetic entropy change ΔS is an important parameter to measure the performance of a magnetocaloric material. Therefore, the present invention used a superconducting quantum interference device to measure the magnetization curves at different temperatures along the easy magnetization directions of the lithium rare earth fluoride single crystal samples. Then, the obtained magnetization curve data at different temperatures are processed using Maxwell equation, and the relationship between the magnetic entropy change and the temperature change is determined. By applying a small varying magnetic field of 0-20kOe along the easy magnetization direction of the lithium rare earth fluoride single crystal sample, a large isothermal magnetic entropy change is demonstrated by the lithium rare earth fluoride single crystal, in which, LiGdF₄, LiTbF₄, LiHoF₄, LiDyF₄, LiErF₄, LiYbF₄ and LiTmF₄ obtained isothermal magnetic entropy changes of 50.35J·kg⁻¹·K⁻¹, 21.12J·kg⁻¹·K⁻¹, 24.98J·kg⁻¹·K⁻¹, 24.45J·kg⁻¹·K⁻¹, 21.95J·kg⁻¹·K⁻¹, 14.7J·kg⁻¹·K⁻¹ and 0.692J·kg⁻¹·K⁻¹, at temperatures of 1.8K, 4K, 4K, 1.8K, 1.8K, 1.8K, and 18K, respectively.

In the field of solid-state magnetic refrigeration, the thermal conductivity of the magnetocaloric material is closely related to the overall refrigeration efficiency of the device. The thermal conductivity tests of the lithium rare earth fluoride single crystals are conducted using the heat transport option of a comprehensive physical property measurement system. Since the thermal conductivity of lithium rare earth fluoride single crystal at low-temperature is high, therefore, the four-probe method is used for testing to minimize errors, and the samples use a needle-like rectangular shape, with utilization of a cooling measurement method. The thermal conductivity of LiTbF₄ and LiErF₄ reach 50W·K⁻¹·m⁻¹ at 25K.

A magnetic refrigeration method based on lithium rare earth fluoride single crystal, which is characterized in that: using lithium rare earth fluoride single crystal as a magnetic working medium, by applying and removing a magnetic field to the magnetic working medium, the temperature of the magnetic working medium changes, facilitating the transfer of heat with the heat exchanger, thereby achieving the purpose of refrigeration.

The preferred technical solution is:
The magnetic working medium lithium rare earth fluoride single crystal can be one or more of LiGdF₄, LiTbF₄, LiHoF₄, LiDyF₄, LiErF₄, LiYbF₄ and LiTmF₄; when multiple types are used, the expansion of the low-temperature refrigeration range is achieved by mixing and arranging different lithium rare earth fluoride single crystals.

Alternatively, in the process of preparing lithium rare earth fluoride single crystals, two or more rare earth elements (Gd, Tb, Dy, Ho, Er, Tm, and Yb) can also be incorporated, thereby achieving the expansion of the low-temperature refrigeration range.

A magnetic refrigerant device driven by a small magnetic field, characterized in that the device comprises lithium rare earth fluoride single crystal as a magnetic working medium.

The preferred technical solution is:
The magnetic working medium lithium rare earth fluoride single crystal is one or more of LiGdF₄, LiTbF₄, LiHoF₄, LiDyF₄, LiErF₄, LiYbF₄ and LiTmF₄; when multiple types are used, the expansion of the low-temperature refrigeration range is achieved by mixing and arranging different lithium rare earth fluoride single crystals.

Alternatively, in the process of preparing lithium rare earth fluoride single crystals, two or more rare earth elements (Gd, Tb, Dy, Ho, Er, Tm, and Yb) can also be incorporated, thereby achieving the expansion of the low-temperature refrigeration range.

The refrigeration device also comprises a magnetic field applying component, a thermal switch, a heat-sink and a load, wherein, the magnetic field applying component can be selected from a permanent magnet, electromagnet, or superconducting magnet, preferably a permanent magnet, which can effectively simplify the volume of the device and optimize the design of the device; the thermal switch can be selected from mechanical contact type, superconducting type, gas type or magnetic resistance type thermal switches; preferably a superconducting type thermal switch.

The technical effects of the present invention is:
1. Due to phase transitions occurring at low temperatures, when lithium rare earth fluoride single crystals are used as the magnetic working medium in magnetic refrigeration devices, the refrigeration temperature range of the device can be in the low-temperature range below 20K.
2. Lithium rare earth fluoride single crystal has extremely strong magnetic anisotropy, can be saturated with a small magnetic force is applied along the easy magnetization axis direction. Components that provide small magnetic field, such as commonly used permanent magnets, are cheap and small in volume, not only significantly reduce the cost of refrigeration devices, but also optimize the design of the refrigeration device, and expand the application scope of the magnetic refrigeration device to large scientific experimental devices and equipment or operations that require low and ultra-low temperature environment.

The present invention can effectively expand the refrigeration range and fulfil the needs of different refrigeration range by mixing and arranging multiple lithium rare earth fluoride single crystals, further expanding the application scope. Alternatively, expanding of the refrigeration range can also be achieved by incorporating a certain amount of other rare earth elements (Gd, Tb, Dy, Ho, Er, Tm, and Yb) during the process of preparing lithium rare earth fluoride single crystals.

Compared to the isothermal magnetic entropy change of 17.5J·kg⁻¹·K⁻¹ for Gd₃Ga₅O₁₂ currently used in the mainstream, LiGdF₄, LiTbF₄, LiHoF₄, LiDyF₄, LiErF₄, LiYbF₄ and LiTmF₄ obtained magnetic entropy changes of 50.35J·kg⁻¹·K⁻¹, 21.12J·kg⁻¹·K⁻¹, 24.98J·kg⁻¹·K⁻¹, 24.45J·kg⁻¹·K⁻¹, 21.95J. kg⁻¹·K⁻¹, 14.7J·kg⁻¹·K⁻¹ and 0.692J·kg⁻¹·K⁻¹, at temperatures of 1.8K, 4K, 4K, 1.8K, 1.8K, 1.8K, and 18K, respectively. With these excellent features of lithium rare earth fluoride single crystals, the mainstream materials can be fully replaced by the lithium rare earth fluoride single crystals, and the lithium rare earth fluoride single crystals can be widely used in low-temperature magnetic refrigeration fields such as gas liquefaction, ultra-low temperature scientific devices, and aerospace, achieving low-temperature magnetic refrigeration with low-cost, efficient and pollution-free. Lithium rare earth fluoride single crystals have high thermal conductivity in the low-temperature refrigeration range, in which, LiTbF₄ and LiErF₄ have thermal conductivity reaching 50W·K⁻¹·m⁻¹ at 25K, which can accelerate the heat transfer rate of the magnetocaloric material, enhancing the overall efficiency of the magnetic refrigeration device.

The preparation process of lithium rare earth fluoride single crystals is mature and capable of large-scale industrial production, which greatly reduces the cost of materials usage and the manufacturing costs of refrigeration systems, thereby facilitating the rapid and widespread of application.

### BRIEF DESCRIPTION OF THE DRAWINGS

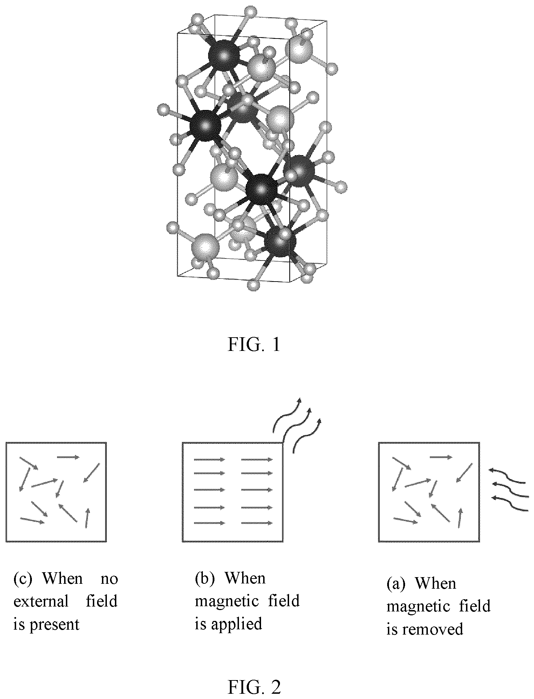

FIG. 1 is a structural view of lithium rare earth fluoride crystal.
FIG. 2 is a schematic view of magnetic refrigeration.

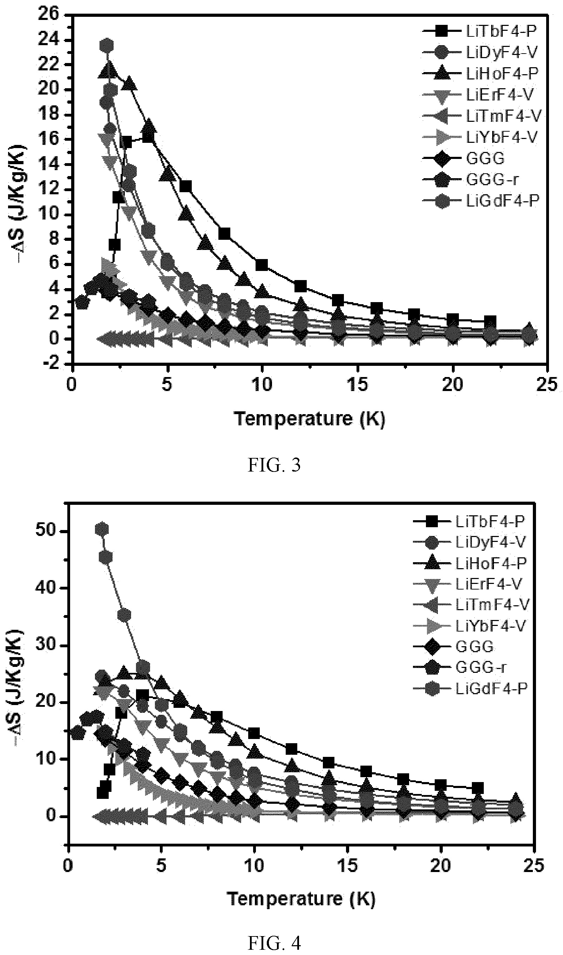

FIG. 3 is a graphical view of the magnetic entropy change curves of gadolinium gallium garnet (GGG) and lithium rare earth fluoride single crystal under the application of a 0-10kOe magnetic field variation along the direction of the easy magnetization axis.
FIG. 4 is a graphical view of the magnetic entropy change curves of gadolinium gallium garnet (GGG) and lithium rare earth fluoride single crystal under the application of a 0-20kOe magnetic field variation along the direction of the easy magnetization axis.

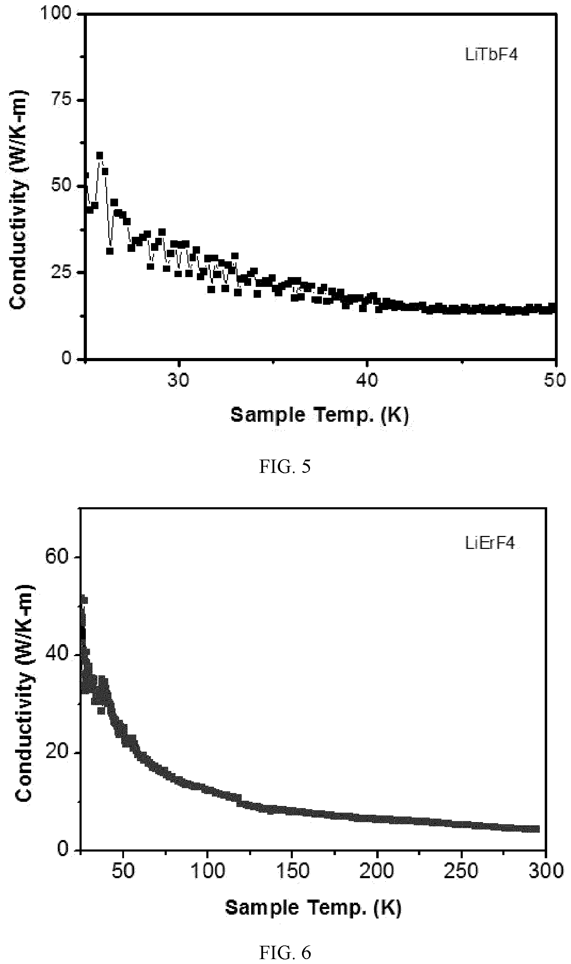

FIG. 5 is a graphical view of the relationship between the thermal conductivity of the LiTbF₄ single crystal and the temperature change.
FIG. 6 is a graphical view of the relationship between the thermal conductivity of the LiErF₄ single crystal and the temperature change..

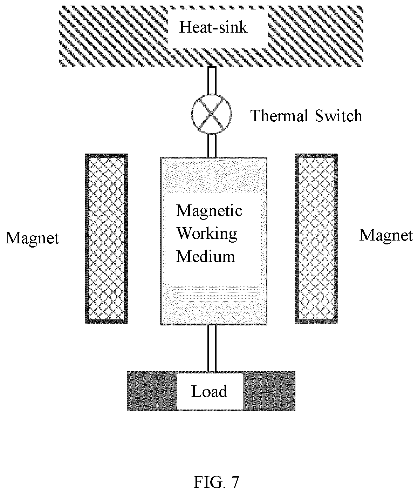

FIG. 7 is a schematic structural view of the magnetic refrigeration device.

### DETAILED DESCRIPTION OF THE PREFERRED EMBODIMENT

An application device of lithium rare earth fluoride single crystal, specifically a magnetic refrigerant device driven by a magnetic field, a magnetic working medium is lithium rare earth fluoride single crystal, specifically one or more of LiGdF₄, LiTbF₄, LiHoF₄, LiDyF₄, LiErF₄, LiYbF₄ and LiTmF₄.

The device also comprises a magnetic field applying component, a thermal switch, a heat-sink and a load. Wherein, the magnetic field applying component can be selected from permanent magnet, electromagnet or superconducting magnet; the thermal switch can be selected from mechanical contact type, superconducting type, gas type or magnetic resistance type thermal switches; the function of the load is to achieve cooling; the head-sink serves the function of dissipating heat. In the initial state, the lithium rare earth fluoride single crystal has the same temperature as the heat-sink under a zero magnetic field condition, then, with the thermal switch remaining closed, the magnetic field increases. During the isothermal magnetization process, heat flows from the magnetic working medium to the heat-sink and the entropy decreases. When the magnetic field reaches maximum, turn on the thermal switch and then reduce the magnetic field, when the temperature of the magnetic working medium drops to the temperature required by the load, some magnetic field is still retained, as the magnetic field continues to decrease, the magnetic working medium will absorb heat from the load to cool the load, thereby achieving the purpose of cooling and fulfilling the refrigeration function of the entire device.

When multiple different lithium rare earth fluoride single crystals are mixed and arranged, the refrigeration range can be effectively expanded. For example, in one embodiment, LiErF₄ and LiTbF₄ are mixed and arranged so that the refrigeration interval is expanded from the temperature range below 6K when using only LiErF₄ to the temperature range below 15K; in another embodiment, LiDyF₄ and LiTbF₄ are mixed and arranged so that the refrigeration range is expanded from the temperature range below 4K when using only LiDyF₄ to the temperature range below 15K, or by incorporating a certain amount of other rare earth elements (Gd, Tb, Dy, Ho, Er, Tm, and Yb) during the process of preparing lithium rare earth fluoride single crystals. Preparing a lithium rare earth fluoride single crystals containing two or more rare earth elements can also achieve the expansion of the low-temperature refrigeration range.

The following embodiments conduct magnetocaloric performance tests on LiGdF₄, LiTbF₄, LiHoF₄, LiDyF₄, LiErF₄, LiYbF₄ and LiTmF₄, respectively. The test results show that in the low-temperature range of less than 20K, LiGdF₄, LiTbF₄, LiHoF₄, LiDyF₄ and LiErF₄ demonstrate an isothermal magnetic entropy change superior to the isothermal magnetic entropy change of traditional GGG material at 17.5 J·kg⁻¹·K⁻¹. Wherein, both LiTbF₄ and LiErF₄ demonstrate thermal conductivity of up to 50W·K⁻¹m⁻¹ in the low-temperature range.

### Embodiment 1 : Magnetocaloric performance test of LiGdF₄ single crystal.

In the magnetic test, a small piece of sample is first cut out from a large LiGdF₄ single crystal sample using a scalpel and is weighed using an electronic balance, the sample has a mass of 7.35mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiGdF₄ sample after applying a varying magnetic field of 0-10kOe and 0-20kOe along the easy magnetization direction is determined using the Maxwell equation. A magnetic entropy change of 50.35J·kg⁻¹ ·K⁻¹ under a varying magnetic field of 0-20kOe for the LiGdF₄ sample is obtained.

### Embodiment 2 : Magnetocaloric performance test of LiTbF₄ single crystal.

In the magnetic test, limited by the measurement range of the instrument, a small piece of sample is first cut out from the large LiTbF₄ single crystal sample using a scalpel and is weighed using an electronic balance, the sample has a mass of 5.4mg. The sample is then fixed in a plastic sample tube using double-sided tape. Next, M-H tests (i.e., magnetization curve test) are conducted along the easy magnetization direction of the sample. Within the temperature range of 1.85K to 2.85K, an M-H curve is measured at intervals of 0.2K; within the temperature range of 4K to 22K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiTbF₄ sample after applying a varying magentic filed of 0-10kOe and 0-20kOe along the easy magnetization direction is determined using the Maxwell equation. A magnetic entropy change of 21.12J·kg⁻¹ ·K⁻¹ under a varying magnetic field of 0-20kOe for the LiTbF₄ sample is obtained.

In the thermal conductivity test of the LiTbF₄ single crystal sample, the thermal conductivity along the C-axis direction of the LiTbF₄ sample is tested using the heat transport option of the comprehensive physical property measurement system, the shape of the sample is rectangular. The four-probe method is used for testing. The cross-sectional area is 9.63mm², the surface area is 109.8mm³, the electrode spacing is 1.5mm and the thermal radiation coefficient is 1. The temperature range of the test is 25K-50K, and a cooling test at a rate at 0.1K/min is carried out, the relationship between the thermal conductivity of the LiTbF₄ sample and the temperature change is then obtained, and the thermal conductivity at 25K reaches 50W·K⁻¹·m⁻¹.

### Embodiment 3: Magnetocaloric performance test of LiDyF₄ single crystal.

In the magnetic test, a small piece of sample is first cut out from the large LiDyF₄ single crystal sample using a scalpel and is weighed using an electronic balance, the sample has a mass of 1.48mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiDyF₄ sample after applying a varying magnetic field of 0-10kOe and 0-20kOe along the easy magnetization direction is determined using the Maxwell equation. A magnetic entropy change of 24.45J·kg⁻¹ ·K⁻¹ under a varying magnetic field of 0-20kOe for the LiDyF₄ sample is obtained.

### Embodiment 4: Magnetocaloric performance test of LiHoF₄ single crystal.

In the magnetic test, a small piece of sample is first cut out from the large LiHoF₄ single crystal sample using a scalpel and is weighed using an electronic balance, the sample has a mass of 6.35mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiHoF₄ sample after applying a varying magnetic field of 0-10kOe and 0-20kOe along the easy magnetization direction is determined using the Maxwell equation. A magnetic entropy change of 24.98J·kg⁻¹ ·K⁻¹ under a varying magnetic field of 0-20kOe for the LiHoF₄ sample is obtained.

### Embodiment 5 : Magnetocaloric performance test of LiErF₄ single crystal.

In the magnetic test, a small piece of sample is first cut out from the large LiErF₄ single crystal sample using a scalpel and is weighed using an electronic balance, the sample has a mass of 2.55mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiErF₄ sample after applying a varying magnetic field of 0-10kOe and 0-20kOe along the easy magnetization direction is determined using the Maxwell equation. A magnetic entropy change of 21.95J·kg⁻¹ ·K⁻¹ under a temperature of 1.8K and a varying magnetic field of 20kOe for the LiErF₄ sample is obtained.

The thermal conductivity test of the LiErF₄ single crystal samples is carried out, wherein, the thermal conductivity along the C-axis direction of the LiErF₄ sample is tested using the heat transport option of the comprehensive physical property measurement system, the shape of the sample is rectangular. The four-probe method is used for testing. The cross-sectional area is 9.3mm², the surface area is 104.37mm³, the electrode spacing is 1.87mm and the thermal radiation coefficient is 1. The temperature range of the test is 25K-300K, and a cooling test at a rate at 0.1K/min is carried out, the relationship between the thermal conductivity of the LiTbF₄ sample and the temperature change is then obtained, and the thermal conductivity at 25K reaches 50W·K⁻¹·m^{-1.}

### Embodiment 6: Magnetocaloric performance test of LiTmF₄ single crystal.

In the magnetic test, a small piece of sample is first cut out from the large LiTmF₄ single crystal sample using a scalpel and is weighed using an electronic balance, the sample has a mass of 82.63mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiTmF₄ sample after applying a varying magnetic field of 0-10kOe and 0-20kOe along the easy magnetization direction is determined using the Maxwell equation. A magnetic entropy change of 0.692J·kg⁻¹ ·K⁻¹ under a varying magnetic field of 0-20kOe for the LiTmF₄ sample is obtained.

### Embodiment 7: Magnetocaloric performance test of LiYbF₄ single crystal.

In the magnetic test, a small piece of sample is first cut out from the large LiYbF₄ single crystal sample using a scalpel and is weighed using an electronic balance, the sample has a mass of 4.81mg. The sample is then fixed in a plastic sample tube using double-sided tape. Next, M-H tests are conducted along the easy magnetization direction of the sample. At a temperature of 1.8K, an M-H curve is measured; within the temperature range of 2K to 10K, an M-H curve is measured at intervals of 1K; within the temperature range of 10K to 24K, an M-H curve is measured at intervals of 2K. In each tested M-H curve, one data point is measured at intervals of 500Oe in the magnetic field range of 0 to 10kOe, and one data point is measured at intervals of 1000Oe in the magnetic field range of 10kOe to 20kOe.

According to the M-H curves obtained from the magnetic tests above at different temperatures, the relationship between the magnetic entropy change and the temperature change of the LiYbF₄ sample after applying a varying magnetic field of 0-10kOe and 0-20kOe along the easy magnetization direction is determined using the Maxwell equation. A magnetic entropy change of 14.7J·kg⁻¹ ·K⁻¹ under a varying magnetic field of 0-20kOe for the LiYbF₄ sample is obtained.

The above embodiments are only for illustrating the technical ideas and the features of the present invention. The purpose is to enable those skilled in the art to understand the content of the present invention and implement the content, and should not limit the scope of protection of the present invention. Any equivalent changes or modifications made in accordance with the essence of the present invention should be included within the protection scope of the present invention.

In addition, descriptions of known structures and techniques are omitted in this document to avoid unnecessary confusion with the concepts of the present invention.

## Claims

1. A use of a lithium rare earth fluoride single crystal in magnetic refrigeration.

2. The use, as recited in claim 1, **characterized in that**: the chemical formula of said lithium rare earth fluoride is LiREF₄, wherein, RE is a rare earth element.

3. The use, as recited in claim 2, **characterized in that**: said rare earth element is one or more of gadolinium, terbium, dysprosium, holmium, erbium, thulium and ytterbium.

4. The use, as recited in claim 3, **characterized in that**: said lithium rare earth fluoride has a tetragonal scheelite structure and is a single crystal with magnetic anisotropy.

5. The use, as recited in claim 4, **characterized in that**: the easy magnetization direction of LiGdF₄, LiTbF₄ and LiHoF₄ are parallel to the C-axis, while the easy magnetization direction of LiDyF₄, LiErF₄, LiYbF₄ and LiTmF₄ are perpendicular to the C-axis.

6. The use, as recited in claim 3, **characterized in that**: LiGdF₄ demonstrates paramagnetism, LiTmF₄ demonstrates Van Vleck paramagnetism, LiTbF₄ and LiHoF4 demonstrate ferromagnetism ordering at temperatures below Curie temperature of 2.87K and 1.53K respectively, LiDyF₄, LiErF₄ and LiYbF₄ demonstrate antiferromagnetism ordering at temperatures below Nel temperature of 0.62K, 0.38K and 0.128K respectively.

7. The use, as recited in claim 1 to 4, **characterized in that**: the application temperature range of said lithium rare earth fluoride single crystal is a low-temperature range below 20K.

8. The use, as recited in claim 1 to 4, **characterized in that**: when a varying magnetic field of 0-20kOe is applied along the easy magnetization direction of said lithium rare earth fluoride single crystal sample, said lithium rare earth fluoride single crystal demonstrates a large isothermal magnetic entropy change, in which, LiGdF₄, LiTbF₄, LiHoF₄, LiDyF₄, LiErF₄, LiYbF₄ and LiTmF₄ obtained isothermal magnetic entropy changes of 50.35J·kg⁻¹·K⁻¹, 21.12J·kg⁻¹·K⁻¹, 24.98J·kg⁻¹·K⁻¹, 24.45J·kg⁻¹·K⁻¹, 21.95J·kg⁻¹·K⁻¹, 14.7J·kg⁻¹·K⁻¹ and 0.692J·kg⁻¹·K⁻¹, at temperature of 1.8K, 4K, 4K, 1.8K, 1.8K, 1.8K and 18K, respectively.

9. The use, as recited in claim 5, **characterized in that**: the thermal conductivity of LiTbF₄ and LiErF₄ reaches 50W·K⁻¹·m⁻¹ at 25K.

10. A magnetic refrigeration method based on lithium rare earth fluoride single crystal, **characterized in that**: using said lithium rare earth fluoride single crystal as a magnetic working medium, by applying and removing a magnetic field to said magnetic working medium, the temperature of said magnetic working medium changes, facilitating the transfer of heat with the heat exchanger, thereby achieving the purpose of refrigeration.

11. The magnetic refrigeration method, as recited in claim 10, **characterized in that**: said lithium rare earth fluoride single crystal can be one or more of LiGdF₄, LiTbF₄, LiHoF₄, LiDyF₄, LiErF₄, LiYbF₄ and LiTmF₄,
when multiple types are used, the expansion of the low-temperature refrigeration range is achieved by mixing and arranging different lithium rare earth fluoride single crystals.

12. The magnetic refrigeration method, as recited in claim 10, **characterized in that**: the chemical formula of said lithium rare earth fluoride is LiREF₄, wherein, RE is a rare earth element, and RE is selected from at least two or more rare earth elements of Gd, Tb, Dy, Ho, Er, Tm and Yb to achieve expansion of the low-temperature refrigeration range.

13. A magnetic refrigerant device driven by a small magnetic field, **characterized in that**: said device comprises lithium rare earth fluoride single crystal as a magnetic working medium.

14. The magnetic refrigerant device, as recited in claim 13, **characterized in that**: said magnetic working medium lithium rare earth fluoride single crystal is one or more of LiGdF₄, LiTbF₄, LiHoF₄, LiDyF₄, LiErF₄, LiYbF₄ and LiTmF₄,
when multiple types are used, the expansion of the low-temperature refrigeration range is achieved by mixing and arranging different lithium rare earth fluoride single crystals.

15. The magnetic refrigerant device, as recited in claim 13, **characterized in that**: the chemical formula of said lithium rare earth fluoride is LiREF₄, wherein, RE is a rare earth element, and RE is selected from at least two or more rare earth elements of Gd, Tb, Dy, Ho, Er, Tm and Yb.

16. The magnetic refrigerant device, as recited in claim 13, **characterized in that**: said magnetic refrigerant device also comprises a magnetic field applying component, a thermal switch, a heat-sink and a load.

17. The magnetic refrigerant device, as recited in claim 13, **characterized in that**: said magnetic field applying component is a permanent magnet, and said thermal switch is a superconducting thermal switch.
